# EUROPEAN PATENT SPECIFICATION

(11) **EP 4 084 329 B1**
(45) Date of publication and mention of the grant of the patent: **11.03.2026**
(21) Application number: 20916092.8
(22) Date of filing: 20.01.2020
(51) Int. Cl.: H03F 3/16, H03F 3/195, H03F 3/45, H03F 1/22

(54) **STACK AMPLIFIER, RADIO FREQUENCY TRANSCEIVER CIRCUIT, DEVICE AND SWITCH CONTROL METHOD**
STAPELVERSTÄRKER, HOCHFREQUENZ-SENDE-/EMPFANGSSCHALTUNG, VORRICHTUNG UND SCHALTSTEUERUNGSVERFAHREN
AMPLIFICATEUR EMPILÉ, CIRCUIT ÉMETTEUR-RÉCEPTEUR RADIOFRÉQUENCE, DISPOSITIF, ET PROCÉDÉ DE COMMANDE DE COMMUTATEUR

(43) Date of publication of application: 02.11.2022
(73) Proprietor: Huawei Technologies Co., Ltd., Shenzhen, Guangdong 518129, (CN)
(72) Inventor: HAN, Kefeng, Shenzhen, Guangdong 518129 (CN); LU, Lei, Shenzhen, Guangdong 518129 (CN)
(74) Representative: Maiwald GmbH
(86) International application number: PCT/CN2020/073243
(87) International publication number: WO 2021/146843

(56) References cited:
- CN-A- 102 969 995
- CN-A- 105 515 542
- CN-A- 105 765 858
- CN-A- 106 230 392
- CN-A- 109 167 574
- US-A1- 2014 049 322
- US-A1- 2019 115 880
- US-A1- 2020 007 088
- US-B1- 10 056 874

## Description

### TECHNICAL FIELD

This application relates to electronic technologies, and in particular, to a stacked amplifier, a radio frequency transceiver circuit, a device, and a switching control method.

### BACKGROUND

In an electronic control application, to facilitate subsequent signal transmission or processing, an amplifier usually needs to be disposed to amplify a signal.

To ensure a signal amplification effect, a stacked amplifier with a plurality of amplifiers may be configured to amplify a signal. Currently, an impedance of a transistor in a stacked amplifier is generally fixed, and consequently an off impedance cannot meet a requirement. Therefore, if a circuit in which the stacked amplifier is located requires state switching, a switch component needs to be additionally disposed to perform state switching.

US 2019/115880 A1 describes that a low-noise amplifier in a receiver supporting a beam forming function may selectively change a phase shift for beam steering. The low-noise amplifier may include first and second transistors and a variable capacitance circuit connected to a gate of the second transistor. The variable capacitance circuit may selectively change capacitance thereof based on a capacitance control signal applied thereto according to beamforming information, where the changed capacitance correspondingly causes a phase change in an output signal of the low-noise amplifier. A similar scheme may be employed for amplifiers in transmit signal paths to steer a transmit beam.

US 2020/007088 A1 describes circuital arrangements for biasing one or more gates of stacked transistors of an amplifier, where the amplifier can have a varying supply voltage. In an example, the gate of the input transistor of the amplifier is biased with a fixed voltage whereas the gates of the other transistors of the amplifier are biased with variable voltages that are linear functions of the varying supply voltage. In another example, the linear functions are such that the variable voltages coincide with the fixed voltage at a value of the varying supply voltage for which the input transistor is at the edge of triode. In a further example, biasing of the stacked transistors is such that, while the supply voltage varies, the drain-to-source voltage of the input transistor is maintained to a fixed value whereas the drain-to-source voltages of all other transistors are equal to one another.

However, the additional switch component is disposed to perform state switching, a large loss of the circuit is caused, and performance of the circuit for a high-frequency signal is greatly reduced.

### SUMMARY

Embodiments of this application provide a stacked amplifier, a radio frequency transceiver circuit, a device, and a switching control method, to reduce a loss of a circuit and improve performance of the circuit for a high-frequency signal. The invention is set out in the appended set of claims.

### BRIEF DESCRIPTION OF DRAWINGS

FIG. 1A is a schematic diagram of an application example 1 of a stacked amplifier according to an embodiment of this application;
FIG. 1B is a schematic diagram of an application example 2 of a stacked amplifier according to an embodiment of this application;
FIG. 1C is a schematic diagram of an application example 3 of a stacked amplifier according to an embodiment of this application;
FIG. 1D is a schematic diagram of a signal flow and a high-impedance state of a stacked amplifier in the application example 3 according to an embodiment of this application;
FIG. 1E is another schematic diagram of a signal flow and a high-impedance state of a stacked amplifier in the application example 3 according to an embodiment of this application;
FIG. 1F is a schematic diagram of an application of a stacked amplifier in a radio frequency field according to an embodiment of this application;
FIG. 2 is an example diagram of an application of a stacked amplifier in a radio frequency transceiver circuit according to an embodiment of this application;
FIG. 3 is a schematic diagram of a structure of a communication device according to an embodiment of this application;
FIG. 4 is a diagram of a structure of a circuit of a stacked amplifier according to an embodiment of this application;
FIG. 5 is a diagram of a structure of a circuit of another stacked amplifier according to an embodiment of this application;
FIG. 5A is a schematic diagram of a stacked amplifier whose variable capacitive device is an N-type MOS capacitor according to an embodiment of this application;
FIG. 5B is another schematic diagram of a stacked amplifier whose variable capacitive device is an N-type MOS capacitor according to an embodiment of this application;
FIG. 5C is still another schematic diagram of a stacked amplifier whose variable capacitive device is an N-type MOS capacitor according to an embodiment of this application;
FIG. 6 is a schematic diagram of a stacked amplifier with a differential structure according to an embodiment of this application;
FIG. 7 is a schematic diagram of a multi-stage stacked amplifier according to an embodiment of this application;
FIG. 8 is a schematic diagram of a stacked amplifier using an N-type MOS transistor according to an embodiment of this application;
FIG. 9 is a schematic diagram of a stacked amplifier using an NPN transistor according to an embodiment of this application;
FIG. 10 is a schematic diagram of another stacked amplifier with a differential structure according to an embodiment of this application;
FIG. 11 is an equivalent circuit diagram of another stacked amplifier with a differential structure in an off state according to an embodiment of this application;
FIG. 12 is a curve diagram of a change between a bias voltage and a capacitance value of an alternating-current ground capacitor of another stacked amplifier with a differential structure according to an embodiment of this application;
FIG. 13 is a curve diagram of a change between a signal frequency and a capacitance value of an alternating-current ground capacitor of a second MOS transistor in another stacked amplifier with a differential structure according to an embodiment of this application;
FIG. 14 is a curve diagram of a change between a signal frequency and an impedance of a second MOS transistor in another stacked amplifier with a differential structure according to an embodiment of this application; and
FIG. 15 is a schematic flowchart of a switching control method according to an embodiment of this application.

### DESCRIPTION OF EMBODIMENTS

A stacked amplifier provided in the following embodiments of this application may be used in any type of signal processing circuit. The signal processing circuit may be an independent processing chip, or may be a circuit module on another chip. The stacked amplifier may be configured to amplify an input signal, and then output the amplified signal.

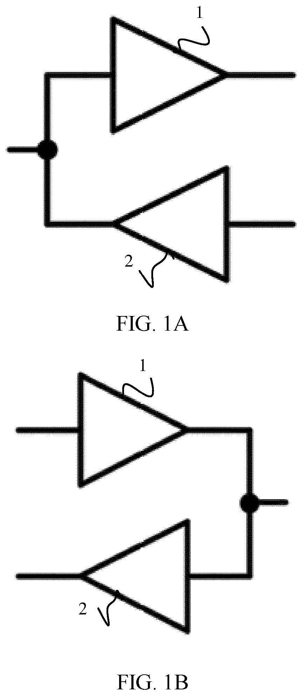

The stacked amplifier may be used in a bidirectional transmit/receive scenario. The following describes some implementations in the bidirectional transmit/receive scenario by using examples with reference to the accompanying drawings. FIG. 1A is a schematic diagram of an application example 1 of a stacked amplifier according to an embodiment of this application. FIG. 1B is a schematic diagram of an application example 2 of a stacked amplifier according to an embodiment of this application. As shown in FIG. 1A, in an application example of a transmit/receive link in the bidirectional transmit/receive scenario, a first stacked amplifier 1 and a second stacked amplifier 2 each have one side that may be connected to a bidirectional external interface, and the other side that may be connected to a unidirectional external interface. The bidirectional external interface may include an antenna interface. The bidirectional external interface connected to an input end of the first stacked amplifier 1 may be an antenna interface. The first stacked amplifier 1 is connected to an antenna through the antenna interface, to receive a signal received by the antenna, so as to amplify the signal received by the antenna. The external interface connected to an output side of the second stacked amplifier 2 may be an antenna interface. The second stacked amplifier 2 may be connected to the antenna through the antenna interface, to send an amplified signal to the antenna.

As shown in FIG. 1B, in another application example of the transmit/receive link in the bidirectional transmit/receive scenario, the first stacked amplifier 1 and the second stacked amplifier 2 each have one side that may be connected to a bidirectional external interface, and the other side that may be connected to a unidirectional external interface. The bidirectional external interface may include an intermediate frequency interface. The external interface connected to an output side of the first stacked amplifier 1 may be an intermediate frequency interface. The first stacked amplifier 1 may be connected to a radio frequency circuit through the intermediate frequency interface, to transmit the amplified signal to the radio frequency circuit. The external interface connected to an input side of the second stacked amplifier 2 may be an intermediate frequency interface. The second stacked amplifier 2 may be connected to the radio frequency circuit through the intermediate frequency interface, to receive an intermediate frequency signal from the radio frequency circuit, so as to amplify the intermediate frequency signal.

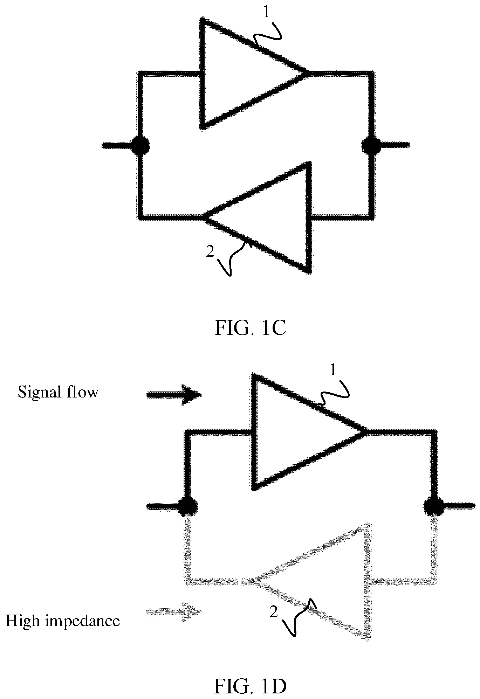

FIG. 1C is a schematic diagram of an application example 3 of a stacked amplifier according to an embodiment of this application. As shown in FIG. 1C, in another application example of the transmit/receive link in the bidirectional transmit/receive scenario, both sides of the first stacked amplifier 1 and the second stacked amplifier 2 are connected to bidirectional external interfaces. For example, the first stacked amplifier 1 and the second stacked amplifier 2 whose both sides are connected to the bidirectional external interface may be used in an intermediate stage of a radio frequency transmit/receive link. The first stacked amplifier 1 in FIG. 1C may input a signal from the bidirectional external interface connected to an input side, amplify the signal, and then output the amplified signal through the bidirectional external interface connected to an output side. The second stacked amplifier 2 may input a signal from the bidirectional external interface connected to an input side, amplify the signal, and then output the amplified signal through the bidirectional external interface connected to an output side.

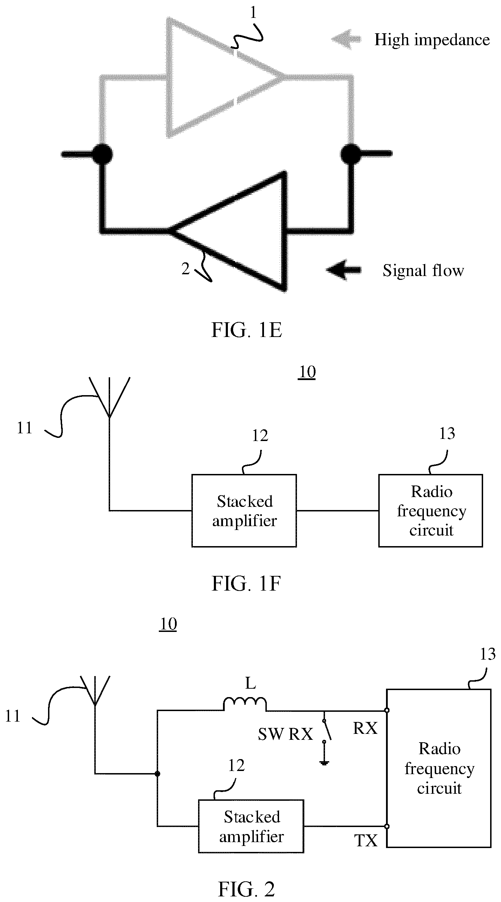

The following describes a signal flow and switching between two high-impedance states in the application example of both sides being connected to the bidirectional external interfaces. FIG. 1D is a schematic diagram of a signal flow and a high-impedance state of a stacked amplifier in the application example 3 according to an embodiment of this application. FIG. 1E is another schematic diagram of a signal flow and a high-impedance state of a stacked amplifier in the application example 3 according to an embodiment of this application. As shown in FIG. 1D and FIG. 1E, in this application example of the transmit/receive link in the bidirectional transmit/receive scenario, both sides of the first stacked amplifier 1 and the second stacked amplifier 2 are connected to the bidirectional external interfaces. When the first stacked amplifier 1 amplifies and transmits a signal, the second stacked amplifier 2 presents a high-impedance state, and does not affect a direction of a signal flow on the first stacked amplifier 1. When the second stacked amplifier 2 amplifies and transmits a signal, the first stacked amplifier 1 presents a high-impedance state, and does not affect a direction of a signal flow on the second stacked amplifier 2.

If the stacked amplifier provided in the following embodiments of this application is used in the foregoing application examples, when one stacked amplifier is in an operating state, another stacked amplifier is in a high-impedance state instead of a low-impedance state, so that a signal flow of the stacked amplifier in the operating state can be prevented from entering a branch in which the another stacked amplifier is located, to reduce a loss.

The stacked amplifier mentioned in this application may be used in the radio frequency field, and is configured to amplify a radio frequency signal. In other words, the bidirectional transmit/receive scenario in the foregoing application examples may be a bidirectional transmit/receive scenario in the radio frequency field. Certainly, the stacked amplifier provided in this embodiment of this application not only can amplify a radio frequency signal, but also can amplify another signal having a preset frequency. This is not limited in this embodiment of this application.

It should be understood that technical solutions of this application may be specifically applied to any one of the following communication systems, to amplify a radio frequency signal on a corresponding frequency band in each communication system. The technical solutions of this application may be applied to various communication systems, for example, a global system for mobile communication (GSM), a code division multiple access (CDMA) system, a wideband code division multiple access (WCDMA) system, a time division-synchronous code division multiple access (TD-SCDMA) system, a time division duplexing (TDD) system, a universal mobile telecommunication system (UMTS), and a long term evolution (LTE) system. With continuous development of communication technologies, the technical solutions of this application may be further applied to a future network, for example, a fifth-generation mobile communication technology (5G) system, may also be referred to as a new radio (NR) system, a device-to-device (D2D) system, or a machine-to-machine (M2M) system.

The following uses an application example of a stacked amplifier in the radio frequency field for description. FIG. 1F is a schematic diagram of an application of a stacked amplifier in a radio frequency field according to an embodiment of this application. As shown in FIG. 1F, a radio frequency transceiver circuit 10 to which the stacked amplifier provided in this embodiment of this application is applied may include an antenna 11, a stacked amplifier 12, and a radio frequency circuit 13. The stacked amplifier 12 is connected between the antenna 11 and the radio frequency circuit 13, and may be configured to amplify a radio frequency signal transmitted between the antenna 11 and the radio frequency circuit 13, and then transmit the amplified radio frequency signal to a peer end.

Signal transmission between the antenna 11 and the radio frequency circuit 13 is usually bidirectional, that is, the radio frequency transceiver circuit 10 may generally have a send path and a receive path. The radio frequency circuit 13 is integrated with a transmit end and a receive end. The send path is also referred to as a transmit path, and is a path for transmission from the transmit end on the radio frequency circuit 13 to the antenna 11. The receive path is a path for transmission from the antenna 11 to the receive end on the radio frequency circuit 13.

In the radio frequency transceiver circuit 10 provided in this embodiment, the send path and the receive path share the same antenna 11. Therefore, when the send path is in an operating state, a receive end of the receive path may present a high-impedance state. On the contrary, when the receive path is in an operating state, a transmitter of the send path may present a high-impedance state.

On at least one of the send path and the receive path of the radio frequency transceiver circuit 10 shown in FIG. 1F in this application, the stacked amplifier provided in the following embodiments may be disposed, so that the stacked amplifier has a high impedance in an off state based on different impedances of the stacked amplifier in different states. This implements a high impedance of a path in which the stacked amplifier is located, and the antenna is in an operating state on another path of the radio frequency transceiver circuit 10. In other words, the stacked amplifier 12 may be used on the send path of the radio frequency transceiver circuit 10, or may be used on the receive path of the radio frequency transceiver circuit 10, or may be used on both the send path and the receive path of the radio frequency transceiver circuit 10.

If the stacked amplifier 12 is used on the send path, the stacked amplifier may also be referred to as a radio frequency amplifier, a radio frequency amplification circuit, or a power amplifier (PA). On the send path, an input end of the stacked amplifier 12 may be connected to a send port of the radio frequency circuit 13, and an output end of the stacked amplifier 12 is connected to the antenna 11.

If the stacked amplifier 12 is used on the receive path, the stacked amplifier may also be referred to as a low noise amplifier (LNA). On the receive path, an input end of the stacked amplifier 12 may be connected to the antenna 11, and an output end of the stacked amplifier 12 is connected to a receive port of the radio frequency circuit 13.

In a possible example, the following describes an application implementation of applying the stacked amplifier 12 to the send path of the radio frequency transceiver circuit 10. On the send path, the stacked amplifier may amplify a radio frequency signal generated by the radio frequency circuit. FIG. 2 is an example diagram of an application of the stacked amplifier in the radio frequency transceiver circuit according to an embodiment of this application. As shown in FIG. 2, the radio frequency circuit 13 may have a send port TX and a receive port RX. An input end of the stacked amplifier 12 may be connected to the send port TX of the radio frequency circuit 13, to obtain, from the send port TX, a radio frequency input (RFᵢₙ) signal generated by the radio frequency circuit 13. An output end of the stacked amplifier 12 may be connected to an antenna 11, to transmit, by using the antenna 11, a radio frequency output (RFₒᵤₜ) signal obtained by amplifying the radio frequency input signal.

In this embodiment, for the send path of the radio frequency transceiver circuit 10, different impedances in an on state and an off state may be implemented by using the stacked amplifier 12 in the following embodiments of this application, so that the impedance of the stacked amplifier 12 in an off state is greater than a preset impedance, to implement a high impedance in an off state. The preset impedance may be greater than or equal to an impedance of the stacked amplifier in the on state.

On a receive path of the radio frequency transceiver circuit 10, the antenna 11 may be connected to the receive port RX of the radio frequency circuit 13 by using an inductor L. The receive port RX is further connected to a receive switch (SW RX). In other words, on the receive path, a changeover switch may be configured to implement a high impedance in an off state.

It should be noted that in the radio frequency transceiver circuit 10 shown in FIG. 1F or FIG. 2, another circuit component may be further connected between the radio frequency circuit 13 and the antenna 11. This is not limited in this application.

The stacked amplifier and the radio frequency transceiver circuit provided in technical solutions of this application may be used in any communication device that has a wireless communication function. The communication device may be a wireless network device such as a base station, or may be a wireless terminal device.

The wireless terminal device in this application may be a device that provides a user with voice and/or data connectivity, a handheld device with a wireless connection function, or another processing device connected to a wireless modem. The wireless terminal device may communicate with one or more core networks through a radio access network (RAN). For example, the wireless terminal device may be a wireless mobile terminal, for example, a mobile phone (cellular phone) and a computer having a mobile terminal, or may be a portable, pocket-sized, handheld, computer built-in, or vehicle-mounted wireless mobile apparatus or a wireless Internet of Things device, for example, a personal communication service (PCS) phone, a cordless phone, a session initiation protocol (SIP) phone, a wireless local loop (WLL) station, or a personal digital assistant (PDA), which exchanges voice and/or data with a radio access network. Optionally, the terminal may also be referred to as user equipment (UE), a mobile station (MS), a mobile terminal, a subscriber unit (SU), a subscriber station (SS), a mobile station (MB), a remote station (RS), an access point (AP), a remote terminal (RT), an access terminal (AT), or a user terminal (UT), a user agent (UA), a terminal device (UD), user equipment (UE), or the like. This is not limited in this application.

In this application, the base station may be a device that communicates with a terminal by using one or more sectors on an air interface in an access network, and may coordinate attribute management of the air interface. For example, the radio access network device may be a base station in GSM or CDMA, for example, a base transceiver station (BTS), or may be a base station in WCDMA, for example, a NodeB, or may be an evolved NodeB in LTE, for example, an eNB or an e-NodeB (evolutional NodeB), or may be a base station in a 5G system, for example, a transmission reception point (TRP) or a g-NodeB (gNB), or a base station in a future network. This is not limited in this application. Optionally, the base station may be a relay device, or another network element device having a base station function.

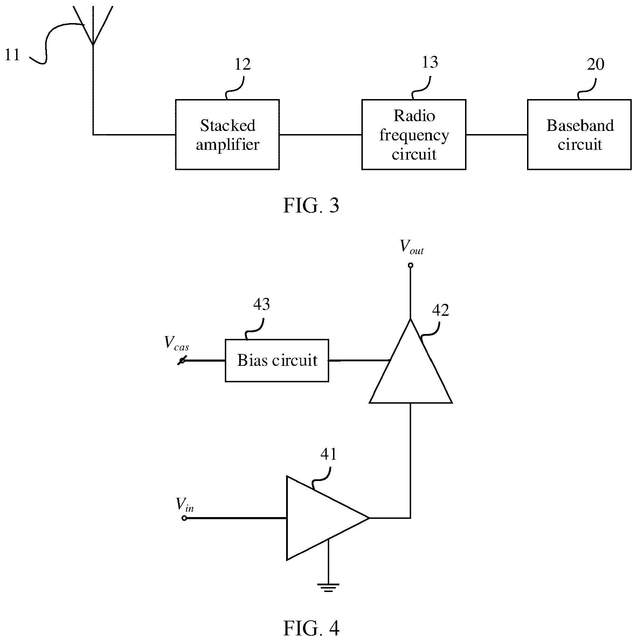

The following describes the communication device provided in this application by using an example. FIG. 3 is a schematic diagram of a structure of a communication device according to an embodiment of this application. As shown in FIG. 3, in this technical solution of this application, based on the radio frequency transceiver circuit 10 shown in FIG. 1F or FIG. 2, the communication device may further include a baseband circuit 20. The baseband circuit 20 may be connected to a radio frequency circuit 13 in the radio frequency transceiver circuit 10. The radio frequency circuit 13 may transform a baseband signal output by the baseband circuit 20 into a radio frequency input signal, and output the radio frequency input signal to the stacked amplifier 12, so that the stacked amplifier 12 amplifies the radio frequency input signal to obtain a radio frequency output signal, and transmits the radio frequency output signal by using an antenna 11.

Optionally, the radio frequency circuit 13 may further transmit a generated bias voltage to the stacked amplifier 12, so that the stacked amplifier 12 has different impedances under an effect of a bias voltage, and an impedance of the stacked amplifier 12 in an off state is greater than a preset impedance. This implements a high impedance of the stacked amplifier 12 in an off state, and therefore implements control over on/off switching of the stacked amplifier 12.

According to the stacked amplifier, the radio frequency transceiver circuit, and the communication device in this application, a bias circuit in the stacked amplifier may be improved, so that the stacked amplifier has different impedances under an effect of a bias voltage and under an effect of different bias voltages, and an impedance in an off state is greater than a preset impedance. This implements a high impedance in an off state without a changeover switch, and reduces a bidirectional loss of a circuit, and improves bidirectional port performance of the circuit.

With reference to a plurality of examples, the following explains and describes the stacked amplifier provided in embodiments of this application and an implementation principle. The stacked amplifier is also referred to as a stacked transistor amplifier, and is an amplifier formed by stacking a plurality of stages of transistors. The stacking of transistors refers to that an output end of a previous stage of transistor is connected to an input end of a next stage of transistor, to input a signal amplified by the previous stage of transistor to the input end of the next stage of transistor, so that the signal is amplified by the next stage of transistor, and a voltage of the amplified signal output by the stacked amplifier is shared by the plurality of stages of amplifier.

FIG. 4 is a diagram of a structure of a circuit of a stacked amplifier according to an embodiment of this application. As shown in FIG. 4, the stacked amplifier may include a first transistor 41, a second transistor 42, and a bias circuit 43.

A bias end of the first transistor 41 is grounded. An input end of the first transistor 41 is configured to receive an input signal. An output end of the first transistor 41 is connected to an input end of the second transistor 42.

A bias end of the second transistor 42 is connected to a control output end of an external circuit through the bias circuit 43, to receive a bias voltage that is output by the external circuit through the control output end. An output end of the second transistor 42 is configured to output an amplified signal. The bias circuit 43 is configured to implement that, under an effect of different bias voltages, the second transistor 42 has different impedances, and an off impedance of the second transistor 42 is greater than a preset impedance. The off impedance is an impedance of the second transistor 42 under an effect of an off bias voltage. The preset impedance may be greater than or equal to an on impedance. The on impedance may be an impedance of the second transistor 42 under an effect of an on bias voltage. The external circuit may be, for example, a radio frequency circuit in the radio frequency field or another control circuit.

During specific implementation, the first transistor 41 may be a first stage of transistor of the stacked amplifier. The input end of the first transistor 41 is an input end of the stacked amplifier, and may be connected to a first external signal end, to receive an input signal from the first external signal end. The bias end of the first transistor 41 is grounded, so that the first transistor 41 can amplify the input signal.

The input end of the second transistor 42 is connected to the output end of the first transistor 41, to obtain an amplified signal of the first transistor 41. The output end of the second transistor 42 is an output end of the stacked amplifier, and may be connected to a second external signal end, to output an output signal amplified by the second transistor 42, to the second external signal end. The bias end of the second transistor 42 is connected to the bias circuit 43. The bias circuit 43 may obtain the bias voltage from the control output end of the external circuit. The bias voltage may be an on bias voltage (V_{ON}), or an off bias voltage (V_{OFF}). When the bias voltage obtained by the bias circuit 43 is the on bias voltage, the bias circuit 43 may implement an amplification function by using the second transistor 42 under an effect of the on bias voltage, to amplify the signal amplified by the first transistor 41 again.

For the stacked amplifier, a signal voltage amplified by the stacked amplifier may be a sum of a voltage amplified by the first transistor 41 and a voltage amplified by the second transistor 42.

In a possible application example, if the stacked amplifier is used on a send path of a radio frequency transceiver circuit, the input end of the first transistor 41 may be connected to a radio frequency circuit in the radio frequency transceiver circuit. The radio frequency circuit may have a send port and a receive port. In an implementation of this example, the input end of the first transistor 41 may be connected to the send port of the radio frequency circuit, to obtain a radio frequency input signal generated by the radio frequency circuit. The output end of the second transistor 42 may be connected to an antenna, to output a radio frequency output signal amplified by the second transistor 42 to the second external signal end. In other words, in this embodiment, the first external signal end connected to the input end of the first transistor 41 may be the send port of the radio frequency circuit. The second external signal end connected to the output end of the second transistor 42 may be the antenna.

In another possible application example, if the stacked amplifier is used on a receive path of a radio frequency transceiver circuit, the input end of the first transistor 41 may be connected to an antenna in the radio frequency transceiver circuit. In an implementation of this example, the input end of the first transistor 41 may be connected to the antenna, to obtain a radio frequency input signal received by the antenna. In other words, in this embodiment, the first external signal end connected to the input end of the first transistor 41 may be the antenna. The second external signal end connected to the output end of the second transistor 42 may be a receive port of a radio frequency circuit.

According to the stacked transistors provided in this embodiment, the bias circuit 43 may be improved, so that the bias circuit 43 can implement that the second transistor 42 amplifies a signal under an effect of an on bias voltage, and adjust an impedance of the second transistor 42 under an effect of an off bias voltage if a bias voltage changes from the on bias voltage to the off bias voltage. Therefore, the second transistor 42 has different impedances in an on state and an off state. Due to improvement of the bias circuit 43, an off impedance of the second transistor 42 is greater than a preset impedance, that is, the off impedance of the second transistor 42 is increased. This implements a high impedance of the second transistor 42 in an off state, and therefore implements a high impedance of the stacked amplifier in an off state. The preset impedance may be greater than an on impedance. The on impedance may be an impedance of the second transistor 42 under an effect of an on bias voltage.

In a possible implementation example, the bias circuit 43 may include a bias resistor and a variable impedance device. The bias resistor and the variable impedance device may be connected in series between the control output end and the ground. The bias end of the second transistor 42 is connected between the bias resistor and the variable impedance device.

In the stacked transistor amplifier provided in embodiments of this application, each transistor may be a bipolar transistor (BJT) or a field effect transistor (FET). The bipolar transistor may also be referred to as a semiconductor transistor, a crystal transistor, or another description, and may be an NPN-type transistor or a PNP-type transistor. The field effect transistor is also referred to as a unipolar transistor, and may be a junction field effect transistor (JFET) or a metal oxide semiconductor field effect transistor (MOS-FET).

In a possible implementation, if the second transistor 42 is an N-type MOS transistor or an NPN-type transistor, an impedance of the variable impedance device is negatively correlated with the bias voltage, and the on bias voltage is greater than the off bias voltage. In other words, the impedance of the variable impedance device increases as the bias voltage decreases. A larger bias voltage indicates a smaller impedance of the variable impedance device, and a smaller bias voltage indicates a larger impedance of the variable impedance device.

In this implementation, impedance of the second transistor 42 may be adjusted by using the variable impedance device in the bias circuit 43. Because the impedance of the variable impedance device is negatively correlated with the bias voltage, when the on bias voltage is greater than the off bias voltage, the off impedance of the second transistor 42 under an effect of the off bias voltage may be greater than the preset impedance. Therefore, the impedance of the second transistor 42 in an off state is increased.

In another possible implementation, if the second transistor 42 is a P-type MOS transistor or a PNP-type transistor, an impedance of the variable impedance device is positively correlated with the bias voltage, and the on bias voltage is less than the off bias voltage. In other words, the impedance of the variable impedance device increases as the bias voltage increases. A larger bias voltage indicates a larger impedance of the variable impedance device, and a smaller bias voltage indicates a smaller impedance of the variable impedance device.

In the another implementation, the impedance of the second transistor 42 may be adjusted by using the variable impedance device in the bias circuit 43. Because the impedance of the variable impedance device is positively correlated with the bias voltage, when the on bias voltage is less than the off bias voltage, the off impedance of the second transistor 42 under an effect of the off bias voltage may be greater than the preset impedance. This implements the high impedance of the second transistor 42 in an off state.

The variable impedance device shown in any one of the foregoing may be, for example, a variable capacitive device. A capacitance of the variable capacitive device may be adjusted, so that the capacitance of the variable capacitive device decreases under the effect of the off bias voltage. Therefore, the impedance of the second transistor 42 in an off state is increased.

The variable impedance device shown in any one of the foregoing may also be, for example, a variable inductive device. An inductance of the variable inductive device may be adjusted, so that the inductance of the variable inductive device increases under the effect of the off bias voltage. Therefore, the impedance of the second transistor 42 in an off state is increased.

The preset impedance mentioned above may be, for example, an off impedance under the effect of the off bias voltage, that is, a preset fixed off impedance, when a fixed impedance device is disposed in the bias circuit 43.

According to the stacked amplifier provided in this embodiment of this application, the input end of the first transistor may receive the input signal, the output end of the first transistor is connected to the input end of the second transistor, and the bias end of the first transistor is grounded, so that the first transistor can amplify the input signal. Alternatively, the bias end of the second transistor may be connected to the control output end of the external circuit through the bias circuit, to receive the bias voltage output by the external circuit through the control output end. Because the bias circuit includes the bias resistor and the variable impedance device, the second transistor can amplify, under the effect of the on bias voltage, the signal output by the first transistor, and the impedance of the second transistor in an off state is greater than the preset impedance. This implements the high impedance of the second transistor in an off state. The stacked amplifier may amplify the signal by using the first transistor and the second transistor, and may further implement, by using the variable impedance device in the bias circuit of the second transistor, that the impedance of the second transistor in an off state is greater than the preset impedance. This implements the high impedance of the second transistor in an off state, to implement the high impedance of the stacked amplifier in an off state. Therefore, on/off state switching of the stacked amplifier can be implemented without an additional changeover switch, and a loss of a circuit is reduced, to ensure bidirectional port performance of the circuit for the high-frequency signal.

In addition, the variable impedance device in the bias circuit of the second transistor in the stacked amplifier may implement the high impedance of the stacked amplifier in an off state of the high-frequency signal, and avoid a leakage current of a path on which the stacked amplifier is located in an off state. This reduces the loss of the circuit, and ensures bidirectional port performance of the circuit for the high-frequency signal.

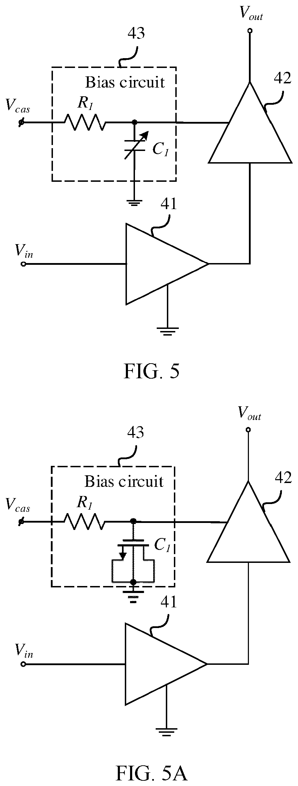

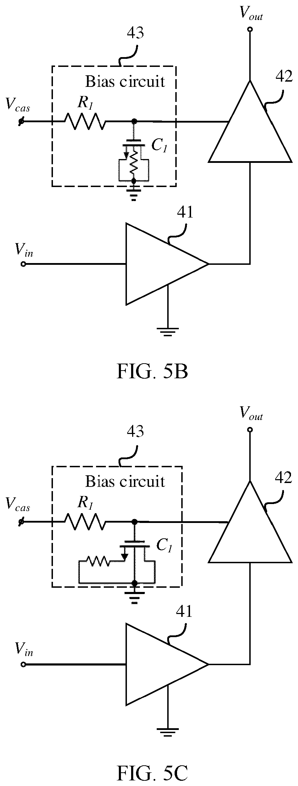

The stacked amplifier provided in this application is described below by using an implementation example in which the variable impedance device disposed in the bias circuit 43 is used as a variable capacitive device to increase the impedance of the second transistor 42 in an off state. FIG. 5 is a diagram of a structure of a circuit of another stacked amplifier according to an embodiment of this application. As shown in FIG. 5, in the stacked amplifier, the bias circuit 43 may include a bias resistor R₁ and a variable capacitive device C₁. The bias resistor R₁ and the variable capacitive device C₁ are connected in series between a control output end and the ground. A bias end of the second transistor 42 is connected between the bias resistor R₁ and the variable capacitive device C₁.

The control output end is the control output end of the external circuit mentioned above. The control output end may be configured to output a bias voltage V_{cas}. In an example, the variable capacitive device C₁ may be implemented in an analog manner, and may be a varactor or a metal-oxide-semiconductor (MOS) capacitor. The variable capacitive device C₁ may also be implemented in a numerical control manner, for example, implemented by using a switched capacitor, that is, a combination of a switch component and a fixed capacitor.

The bias voltage V_{cas} may be an on voltage V_{ON}, also referred to as an on bias voltage, or may be an off voltage V_{OFF}, also referred to as an off bias voltage. The bias resistor R₁ and the variable capacitive device C₁ are connected in series between the control output end and the ground. Under an effect of the on bias voltage, a capacitance value of the variable capacitive device C₁ may be an on capacitance value C_{ON}, so that an on impedance of the second transistor 42 is r_{ON}, and the second transistor 42 is in an amplifying state, to amplify a signal. However, under an effect of the off bias voltage, a capacitance value of the variable capacitive device C₁ may be an off capacitance value C_{OFF}, so that an off impedance of the second transistor 42 is r_{OFF}, and the second transistor 42 is in an off state.

If the second transistor 42 is an N-type MOS transistor or an NPN-type transistor, and the on bias voltage is greater than the off bias voltage, the on capacitance C_{ON} under the effect of the on bias voltage is greater than the off capacitance C_{OFF} under the effect of the off bias voltage, so that the on impedance r_{ON} of the second transistor 42 is less than the off impedance r_{OFF} of the second transistor 42, to increase the on impedance of the second transistor 42.

In a specific implementation example, the MOS capacitor shown above may be an N-type MOS capacitor, or may be a P-type MOS capacitor. The following first describes a connection relationship of the variable capacitive device in the stacked amplifier provided in this embodiment of this application by using an N-type MOS capacitor as an example. FIG. 5A is a schematic diagram of the stacked amplifier whose variable capacitive device is an N-type MOS capacitor according to an embodiment of this application. As shown in FIG. 5A, in the stacked amplifier in this embodiment of this application, the variable capacitive device C₁ may be an N-type MOS capacitor. A gate of the N-type MOS capacitor is connected between the bias resistor R₁ and the bias end of the second transistor 42. A source, a drain, and a substrate of the N-type MOS capacitor are all grounded.

FIG. 5B is another schematic diagram of the stacked amplifier whose variable capacitive device is an N-type MOS capacitor according to an embodiment of this application. As shown in FIG. 5B, in the stacked amplifier in this embodiment of this application, the variable capacitive device C₁ may be an N-type MOS capacitor. A gate of the N-type MOS capacitor is connected between the bias resistor R₁ and the bias end of the second transistor 42. Both a source and a drain of the N-type MOS capacitor are grounded. A substrate of the N-type MOS capacitor is grounded by using a preset resistor.

FIG. 5C is still another schematic diagram of the stacked amplifier whose variable capacitive device is an N-type MOS capacitor according to an embodiment of this application. As shown in FIG. 5C, in the stacked amplifier in this embodiment of this application, the variable capacitive device C₁ may be an N-type MOS capacitor. A gate of the N-type MOS capacitor is connected between the bias resistor R₁ and the bias end of the second transistor 42. Both a drain and a substrate of the N-type MOS capacitor are grounded. A source of the N-type MOS capacitor is grounded by using a preset resistor.

It should be noted that in the stacked amplifier provided in this embodiment of this application, the variable capacitive device may alternatively be the P-type MOS capacitor. In an implementation, a gate of the P-type MOS capacitor is grounded. A source, a drain, and a substrate of the P-type MOS capacitor are all grounded and connected between the bias resistor R₁ and the bias end of the second transistor 42.

In another implementation, a gate of the P-type MOS capacitor is grounded. Both a source and a drain of the P-type MOS capacitor are connected between the bias resistor R₁ and the bias end of the second transistor 42. A substrate of the P-type MOS capacitor is connected between the bias resistor R₁ and the bias end of the second transistor 42 by using a preset resistor.

In still another implementation, a gate of the P-type MOS capacitor is grounded. Both a source and a substrate of the P-type MOS capacitor are connected between the bias resistor R₁ and the bias end of the second transistor 42. A drain of the P-type MOS capacitor is connected between the bias resistor R₁ and the bias end of the second transistor 42 by using a preset resistor.

It should be noted that a connection manner of the N-type MOS capacitor or the P-type MOS capacitor in the stacked amplifier is not limited to the foregoing example, and may be another manner. Details are not described herein.

In this solution of this embodiment, the off impedance of the second transistor may be greater than the preset impedance by using the variable capacitive device in the bias circuit. This implements a high impedance of the second transistor in an off state, and therefore implements a high impedance of the stacked amplifier in an off state. Therefore, on/off state switching of the stacked amplifier can be implemented without an additional changeover switch. The impedance of the second transistor in an off state is increased by using the variable capacitive device, so that a circuit is simpler in structure, lower in loss cost, and easier to implement.

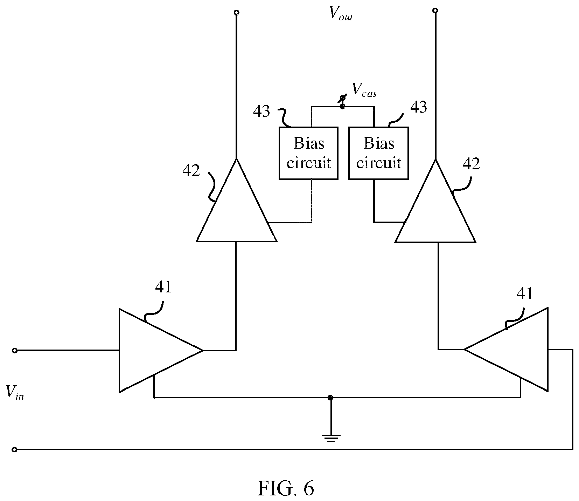

The stacked amplifier shown in any one of the foregoing in this application may be used in a single-ended structure, or may be used in a differential structure, that is, a dual-ended structure. The following uses a stacked amplifier with a differential structure as an example for description. The stacked amplifier with the differential structure is also referred to as a differential amplifier. FIG. 6 is a schematic diagram of a stacked amplifier with a differential structure according to an embodiment of this application. As shown in FIG. 6, the stacked amplifier with the differential structure may include two single-ended amplifiers. Each single-ended amplifier may be similar to the stacked amplifier shown in any one of FIG. 4 or FIG. 5, and may include a first transistor 41, a second transistor 42, and a bias circuit 43.

Differential input ends of the stacked amplifier with the differential structure may be input ends of the first transistors 41 in the two single-ended amplifiers. Both the input ends may receive the input signal. Bias ends of the first transistors 41 in the two single-ended amplifiers are both grounded. Output ends of the first transistors 41 in the two single-ended amplifiers are separately connected to an input end of one second transistor 42.

Differential output ends of the stacked amplifier with the differential structure may be output ends of the second transistors 42 in the two single-ended amplifiers. Both the output ends may output the amplified signal. Bias ends of the second transistors 42 in the two single-ended amplifiers are separately connected to a control output end through one bias circuit 43, to obtain a bias voltage output by the control output end.

The stacked amplifier with the differential structure provided in this embodiment includes two single-ended amplifiers. Each single-ended amplifier may be similar to any one of the foregoing stacked amplifiers, that is, include a first transistor 41, a second transistor 42, and a bias circuit 43. A connection relationship between the first transistor 41, the second transistor 42, and the bias circuit 43 in each single-ended amplifier may be similar to the foregoing connection relationship. Each bias circuit 43 is connected to a control output end, that is, the bias circuits 43 have a same bias voltage.

The stacked amplifier provided in this embodiment of this application is used in a differential structure, so that a high impedance of each stacked amplifier in an off state may be implemented, based on differential amplification. Therefore, on/off switching is implemented without using an additional changeover switch, and a loss of a circuit is reduced, to ensure a performance advantage of the circuit for a high-frequency signal.

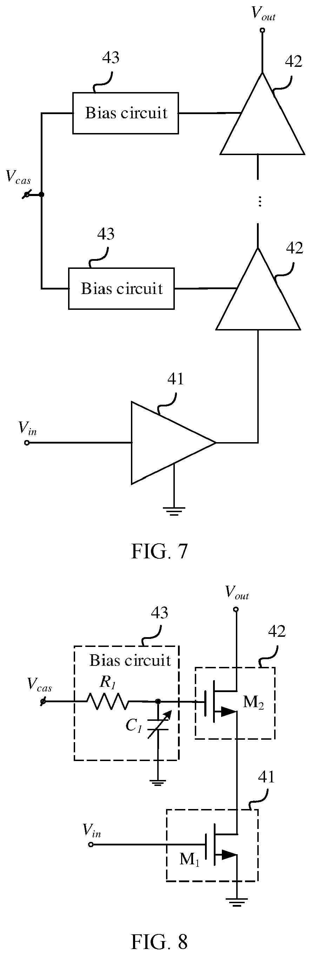

The stacked amplifier shown in any one of the foregoing descriptions may be implemented by being integrated into a chip, or may be implemented as a discrete component, or may allow stacking of more stages. That is, the stacked amplifier shown in any one of the foregoing may include: a plurality of stages of second transistors 42 and a plurality of bias circuits 43. FIG. 7 is a schematic diagram of a multi-stage stacked amplifier according to an embodiment of this application. As shown in FIG. 7, the multi-stage stacked amplifier includes a first transistor 41 and a plurality of stages of second transistors 42. Connection of each port of the first transistor may be similar to that of the first transistor 41 in any one of the foregoing stacking methods. Details are not described herein again. In the plurality of stages of second transistors 42, an input end of a first stage of second transistor 42 is connected to an output end of the first transistor 41. An input end of a back stage of second transistor 42 is connected to an output end of a front stage of second transistor 42. A bias end of each stage of second transistor 42 is connected to a control output end through one bias circuit 43. The bias circuits 43 of the plurality of stages of second transistors 42 may share one bias voltage, that is, all the bias circuits 43 are connected to the control output end of an external circuit to obtain the bias voltage, so that each stage of second transistor 42 may amplify a signal under an effect of an on bias voltage.

In the plurality of stages of second transistors 42, an output end of a last stage of second transistor 42 may be an output end of the stacked amplifier, to output an amplified signal.

According to the multi-stage stacked amplifier provided in this embodiment, multiple amplifications may be performed by using a plurality of stages of second transistors, so that an amplification gain of a signal may be ensured. In this embodiment, the stacked amplifier may be used for multi-stage stacking. If multi-stage amplification is implemented through multi-stage stacking, a high impedance in an off state may be implemented. Therefore, on/off switching is implemented without using an additional changeover switch, and a loss of a circuit is reduced, to ensure bidirectional port performance of the circuit for a high-frequency signal.

It should be noted that, in the stacked amplifier shown in any one of FIG. 3 to FIG. 7, each transistor may be a bipolar transistor or a field-effect transistor.

The stacked amplifier provided in this embodiment of this application is separately described below by using two types of transistors. In a possible implementation, a field-effect transistor may be used, that is, both a first transistor 41 and a second transistor 42 in the stacked amplifier are field-effect transistors. The following uses an N-type MOS transistor as an example for description. FIG. 8 is a schematic diagram of a stacked amplifier using an N-type MOS transistor according to an embodiment of this application. In this embodiment, the stacked amplifier may be an amplifier of a cascode structure. The first transistor 41 may be a common-source transistor, and may be, for example, a first MOS transistor M₁ shown in FIG. 8. The second transistor 42 may be a common-gate transistor, and may be, for example, a second MOS transistor M₂ shown in FIG. 8.

It should be noted that, in this embodiment, the bias circuit 43 is described by using a circuit structure similar to that in FIG. 5 as an example. Alternatively, the bias circuit 43 provided in this embodiment of this application may be of another circuit structure, for example, any structure shown in FIG. 5A, FIG. 5B, or FIG. 5C. This is not limited in this application.

In this embodiment, a gate of the first MOS transistor M₁ may serve as an input end of the first transistor 41, to receive an input signal. A drain of the first MOS transistor M₁ may serve as an output end of the first transistor 41, to output an amplified signal of the first transistor 41. A source of the first MOS transistor M₁ may serve as a bias end of the first transistor 41, and is grounded to provide a bias for the first MOS transistor M₁, so that the first MOS transistor M₁ may be in a saturation area, to reversely implement a signal.

A source of the second MOS transistor M₂ may serve as an input end of the second transistor 42, to receive the signal output by the first transistor 41. A drain of the second MOS transistor M₂ may serve as an output end of the second transistor 42, to output the amplified signal of the second transistor 42. A gate of the second MOS transistor M₂ may serve as a bias end of the second transistor 42, and is connected to the bias circuit 43.

A bias resistor R₁ and a variable capacitive device C₁ may implement that, under an effect of an on bias voltage, the second MOS transistor M₂ is also in a saturation area, to forwardly amplify a signal. In this way, a voltage of the amplified signal output by the stacked amplifier may be shared by the first MOS transistor M₁ and the second MOS transistor M₂.

In addition, a capacitance value of the variable capacitive device C₁ in the bias circuit 43 under an effect of an on bias voltage is an on capacitance C_{ON}, and a capacitance value of the variable capacitive device C₁ under an effect of an off bias voltage is an off capacitance C_{OFF}. If the on bias voltage is greater than the off bias voltage, the off capacitance C_{OFF} of the second MOS transistor M₂ may be less than the on capacitance C_{ON}, so that an off impedance of the second MOS transistor M₂ is increased.

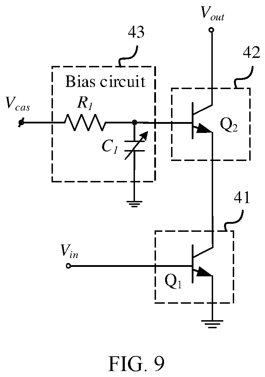

In another possible implementation, a bipolar transistor may be used, that is, both a first transistor 41 and a second transistor 42 in the stacked amplifier use bipolar transistors. The following uses an NPN transistor as an example for description. FIG. 9 is a schematic diagram of a stacked amplifier using an NPN transistor according to an embodiment of this application. In this embodiment, in the stacked amplifier, the first transistor 41 may be a common-emitter transistor, and may be, for example, a first triode Q₁ shown in FIG. 9. The second transistor 42 may be a common-base transistor, and may be, for example, a second triode Q₂ shown in FIG. 9.

It should be noted that, in this embodiment, the bias circuit 43 is described by using a circuit structure similar to that in FIG. 5 as an example. Alternatively, the bias circuit 43 provided in this embodiment of this application may be of another circuit structure, for example, any structure shown in FIG. 5A, FIG. 5B, or FIG. 5C. This is not limited in this application.

In this embodiment, a base of the first triode Q₁ may serve as an input end of the first transistor 41, to receive an input signal. A collector of the first triode Q₁ may serve as an output end of the first transistor 41, to output the amplified signal of the first transistor 41. An emitter of the first triode Q₁ may serve as a bias end of the first transistor 41 and is grounded, so that the first triode Q₁ may be in an amplification area, to reversely amplify a signal.

An emitter of the second triode Q₂ may serve as an input end of the second transistor 42, to receive the signal output by the first transistor 41. A collector of the second triode Q₂ may serve as an output end of the second transistor 42, to output the amplified signal of the second transistor 42. A base of the second triode Q₂ may serve as a bias end of the second transistor 42, and is connected to the bias circuit 43.

A bias resistor R₁ and a variable capacitive device C₁ may implement that, under an effect of an on bias voltage, the second triode Q₂ is also in the amplification area, to forwardly amplify a signal. In this way, a voltage of the amplified signal output by the stacked amplifier may be shared by the first triode Q₁ and the second triode Q₂.

In addition, a capacitance value of the variable capacitive device C₁ in the bias circuit 43 under an effect of an on bias voltage is an on capacitance C_{ON}, and a capacitance value of the variable capacitive device C₁ under an effect of an off bias voltage is an off capacitance C_{OFF}. If the on bias voltage is greater than the off bias voltage, the off capacitance C_{OFF} of the second triode Q₂ may be less than the on capacitance C_{ON}, so that an off impedance of the second triode Q₂ is increased.

FIG. 8 and FIG. 9 show possible implementations in which two different types of transistors are used. In the stacked amplifier provided in this application, each transistor may alternatively be another transistor, and this is not limited to the foregoing. This is not limited in this embodiment of this application.

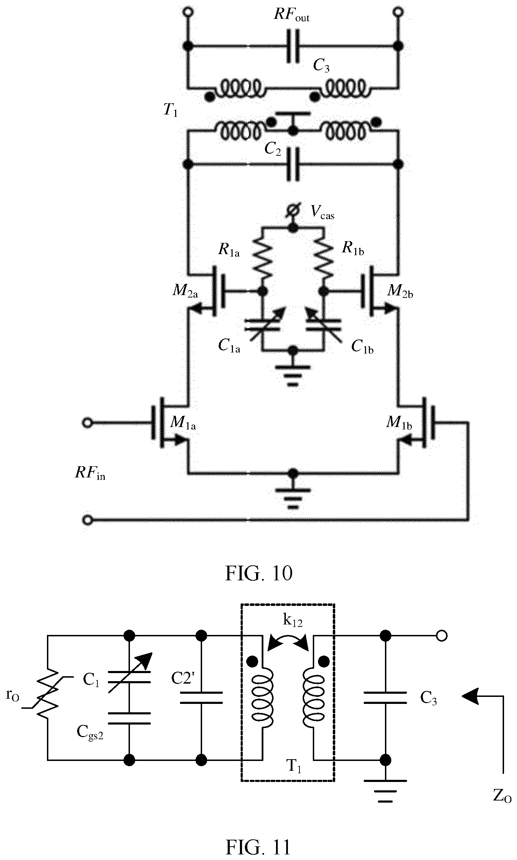

In some other possible implementations, the stacked amplifier provided in this embodiment of this application may further include a transformer. The transformer may also be referred to as an output transformer, and is configured to transform the amplified signal output by the stacked amplifier and then output the transformed signal. A primary coil of the transformer is connected to an output end of the second transistor 42. The transformer is configured to transform the amplified signal, and then output the transformed signal through an output end of a secondary coil. The following provides a description by using a specific example. FIG. 10 is a schematic diagram of another stacked amplifier with a differential structure according to an embodiment of this application. As shown in FIG. 10, the stacked amplifier with the differential structure may include: two first MOS transistors, two second MOS transistors, a transformer T₁, a second capacitor C₂, a third capacitor C₃, and two bias circuits.

A first a transistor M₁ₐ and a first b transistor M_{1b} may serve as input transistors of the stacked transistors. Gates of the first a transistor M₁ₐ and the first b transistor M_{1b} may receive a radio frequency input (RFᵢₙ) signal. Sources of the first a transistor M₁ₐ and the first b transistor M_{1b} are both grounded. A drain of the first a transistor M₁ₐ is connected to a source of a second a transistor M₂ₐ. A drain of the first b transistor M_{1b} is connected to a source of a second b transistor M_{2b}.

The second a transistor M₂ₐ and the second b transistor M_{2b} may be common-gate transistors in the stacked transistors. The two bias circuits are respectively bias circuits of two second MOS transistors. A first a bias resistor R₁ₐ and a first a variable capacitive device C₁ₐ form a bias circuit of the second a transistor M₂ₐ. A first b bias resistor R_{1b} and a first b variable capacitive device C_{1b} form a bias circuit of the second b transistor M_{2b}. The two bias circuits are both connected between a control output end of an external circuit and the ground. A gate of the second a transistor M₂ₐ is connected between the first a bias resistor R₁ₐ and the first a variable capacitive device C₁ₐ. A gate of the second b transistor M_{2b} is connected between the first b bias resistor R_{1b} and the first b variable capacitive device C_{1b}. The first a variable capacitive device C₁ₐ and the first b variable capacitive device C_{1b} are respectively alternating-current ground capacitors of the second a transistor M₂ₐ and the second b transistor M_{2b}.

The transformer T₁ is the output transformer of the stacked transistor. The second capacitor C₂ is a coordinated capacitor connected to the primary coil of the transformer T₁. The third capacitor C₃ is a coordinated capacitor connected to the secondary coil of the transformer T₁. An output end of the secondary coil of the transformer T₁ is an output end of the stacked amplifier, to output a radio frequency output (RFₒᵤₜ) signal.

When the bias voltage output by the control output end is an off bias voltage V_{cas-OFF}, the stacked amplifier is in an off state. FIG. 11 is an equivalent circuit diagram of another stacked amplifier with a differential structure in an off state according to an embodiment of this application. A gate-drain capacitance C2' in FIG. 11 is a sum of gate-drain capacitances (C_{gd}) of the second capacitor C₂, the second a transistor M₂ₐ, and the second b transistor M_{2b} in FIG. 10. A gate-source capacitance C_{gs2} is a sum of gate-source capacitances (C_{gs}) of the second a transistor M₂ₐ and the second b transistor M_{2b}. The alternating-current ground capacitors C₁ are the first a variable capacitive device C₁ₐ and the first b variable capacitive device C_{1b} in FIG. 10. An impedance ro is a real part of an output impedance of the second a transistor M₂ₐ and the second b transistor M_{2b}.

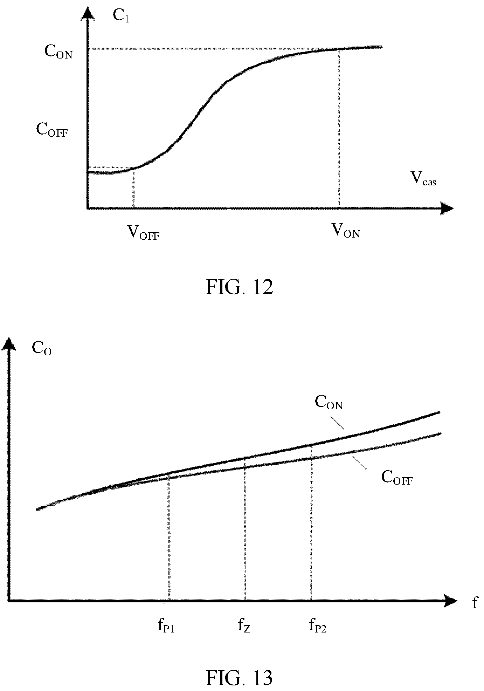

The following provides descriptions with reference to a change curve of a capacitance value of an alternating-current ground capacitor and a bias voltage. FIG. 12 is a curve diagram of a change between a bias voltage and a capacitance value of an alternating-current ground capacitor of the another stacked amplifier with the differential structure according to an embodiment of this application. In the stacked amplifier provided in this application, both the first a variable capacitive device C₁ₐ and the first b variable capacitive device C_{1b} are variable capacitive devices, so that when the bias voltage V_{cas} is an on bias voltage, also referred to as an on voltage V_{ON}, that is, a preset high voltage, the stacked amplifier is in an on state, and the alternating-current ground capacitor C₁ presents a preset on capacitance value C_{ON}. When the bias voltage is an off bias voltage, also referred to as an off voltage V_{OFF}, that is, a preset low voltage, the stacked amplifier is in an off state, the alternating-current ground capacitor C₁ presents a preset off capacitance value C_{OFF}. Refer to FIG. 12, it can be learned that a bias voltage transformation may be converted into a capacitance value change of the alternating-current ground capacitor C₁, to cause an impedance change.

FIG. 13 is a curve diagram of a change between a signal frequency and a capacitance value of an alternating-current ground capacitor of the second MOS transistor in the another stacked amplifier with the differential structure according to an embodiment of this application. It can be learned from FIG. 13 that, as the signal frequency increases, a difference between the on capacitance C_{ON} and the off capacitance C_{OFF} of the alternating-current ground capacitor C₁ becomes larger. For a high-frequency signal, a capacitance value of the alternating-current ground capacitor C₁ of the stacked amplifier in an off state is reduced.

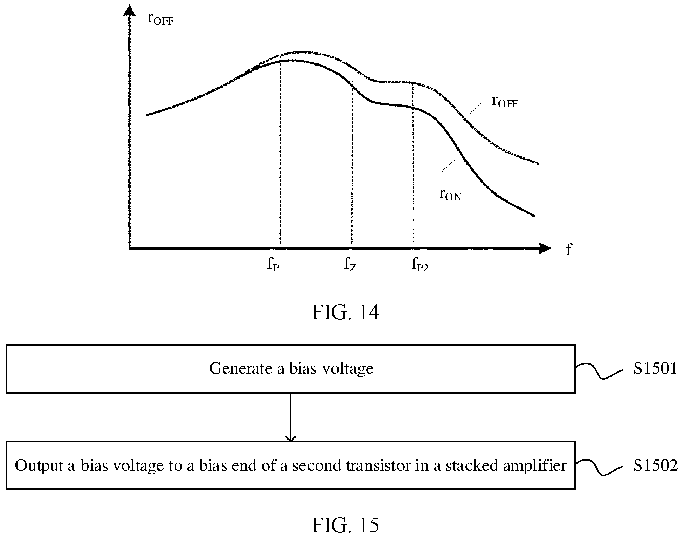

The alternating-current ground capacitor C₁ presents different capacitance values in the on state and an off state, so that the impedance ro presents different impedances and is presented as a variable impedance. Because of an impedance transformation function of the transformer T₁, the transformer T₁ presents different impedances in a preset frequency band. This implements a high impedance of the alternating-current ground capacitor C₁ in an off state under the high-frequency signal. FIG. 14 is a curve diagram of a change between a signal frequency and an impedance of the second MOS transistor in the another stacked amplifier with the differential structure according to an embodiment of this application. It can be learned from FIG. 14 that an on impedance r_{ON} of the impedance ro is less than an off impedance r_{OFF}. In addition, as the signal frequency increases, a difference between the on impedance r_{ON} and the off impedance r_{OFF} becomes larger. In other words, according to the stacked amplifier provided in this embodiment of this application, an effect of disabling a high impedance for the high-frequency signal is more significant than an effect of disabling a high impedance for a low-frequency signal.

To cooperate with the stacked amplifier, the radio frequency transceiver circuit, and the communication device provided in the foregoing embodiments of this application, and to implement on/off switching, this embodiment of this application may further provide a switching control method. FIG. 15 is a schematic flowchart of a switching control method according to an embodiment of this application. As shown in FIG. 15, the method may include the following steps.

S1501. Generate a bias voltage.

S1502. Output a bias voltage to a bias end of a second transistor in the stacked amplifier.

The bias voltage may be used to implement that, under an effect of different bias voltages, the second transistor has different impedances, and an off impedance of the second transistor is greater than a preset impedance. The off impedance is an impedance of the second transistor under an effect of an off bias voltage. The preset impedance may be greater than an on impedance. The on impedance may be an impedance of the second transistor under an effect of an on bias voltage. For example, the preset impedance may be a preset off impedance, that is, an impedance of a fixed impedance device in the bias circuit of the second amplifier under an effect of the off bias voltage.

In the switching control method, the bias voltage may be generated by an external circuit. The bias voltage may be output to the bias end of the second transistor in the stacked amplifier through a control output end of the external circuit. Based on the foregoing stacked amplifier, the bias circuit implements that, under an effect of different bias voltages, the second transistor has different impedances, and the off impedance of the second transistor is greater than the preset impedance.

According to the switching control method, the bias voltage may be generated, and the bias voltage may be output to the stacked amplifier, so that the stacked amplifier presents different impedances under an effect of different bias voltages, to implement a high impedance in an off state, so as to implement on/off state switching. Therefore, on/off state switching of the stacked amplifier can be implemented without an additional changeover switch, a loss of a circuit is reduced, and a leakage current of a path in which the stacked amplifier is located in an off state can be avoided. The loss of the circuit is further reduced, to effectively ensure bidirectional port performance of the circuit for the high-frequency signal.

It should be noted that the "connection" in the foregoing embodiments of this application may be a direct connection or an indirect connection. The direct connection may be, for example, a direct contact connection or a connection by using a wire. The indirect connection may be, for example, a coupling connection or a connection by using another element. A specific form of the connection is not limited in this embodiment of this application.

The foregoing descriptions are merely specific implementations of embodiments of this application, but are not intended to limit the protection scope of embodiments of this application. Any variation or replacement readily figured out by a person skilled in the art within the technical scope disclosed in this present invention shall fall within the protection scope of embodiments of this application. Therefore, the protection scope of embodiments of this application shall be subject to the protection scope of the claims.

## Claims

1. A stacked amplifier, comprising:
- a first transistor (41),
- a second transistor (42), and
- a bias circuit (43),
wherein a bias end of the first transistor (41) is grounded, an input end of the first transistor (41) is configured to receive an input signal, and an output end of the first transistor (41) is connected to an input end of the second transistor (42);
wherein a bias end of the second transistor (42) is connected to a control output end of an external circuit through the bias circuit (43), to receive a bias voltage that is output by the external circuit through the control output end, and an output end of the second transistor (42) is configured to output an amplified signal;
wherein the bias circuit (43) comprises a bias resistor and a variable impedance device which are connected in series between the control output end and the ground, and the bias end of the second transistor (42) is connected between the bias resistor and the variable impedance device; and
**characterized in that** the bias circuit (43) is configured such that, if the bias voltage is an off bias voltage, an impedance of the variable impedance is adjusted such that an off impedance of the second transistor (42) is greater than a preset impedance, so as to implement on/off state switching of the stacked amplifier without an additional changeover switch, wherein the off impedance is an output impedance of the second transistor (42) under an effect of the off bias voltage.

2. The stacked amplifier according to claim 1, wherein the variable impedance device comprises a variable capacitive device.

3. The stacked amplifier according to claim 2, wherein the variable capacitive device comprises a metal oxide semiconductor, MOS, capacitor.

4. The stacked amplifier according to claim 3, wherein the MOS capacitor is an N-type MOS capacitor.

5. The stacked amplifier according to claim 4, wherein a gate of the N-type MOS capacitor is connected between the bias resistor and the bias end of the second transistor (42), and a source, a drain, and a substrate of the N-type MOS capacitor are all grounded.

6. The stacked amplifier according to claim 4, wherein a gate of the N-type MOS capacitor is connected between the bias resistor and the bias end of the second transistor (42), both a source and a drain of the N-type MOS capacitor are grounded, and a substrate of the N-type MOS capacitor is grounded by using a preset resistor.

7. The stacked amplifier according to claim 4, wherein a gate of the N-type MOS capacitor is connected between the bias resistor and the bias end of the second transistor (42), both a drain and a substrate of the N-type MOS capacitor are grounded, and a source of the N-type MOS capacitor is grounded by using a preset resistor.

8. The stacked amplifier according to claim 2, wherein the variable capacitive device comprises a varactor or a switched capacitor.

9. The stacked amplifier according to claim 1, wherein the variable impedance device comprises a variable inductive device.

10. The stacked amplifier according to any one of claims 1 to 9, wherein the stacked amplifier is a differential amplifier; the differential amplifier comprises two single-ended amplifiers, and each single-ended amplifier comprises the first transistor (41), the second transistor (42), and the bias circuit (43); and
a differential input end of the differential amplifier is the input end of the first transistor (41) in each of the two single-ended amplifiers, and a differential output end of the differential amplifier is the output end of the second transistor (42) in each of the two single-ended amplifiers.

11. The stacked amplifier according to any one of claims 1 to 10, wherein the stacked amplifier comprises: a plurality of stages of second transistors (42) and a plurality of bias circuits (43), wherein in the plurality of stages of second transistors (42), an input end of a first stage of second transistor (42) is connected to the output end of the first transistor (41), and an input end of a back stage of second transistor (42) is connected to an output end of a front stage of second transistor (42); and
a bias end of each stage of second transistor (42) is connected to the control output end through one bias circuit (43).

12. The stacked amplifier according to any one of claims 1 to 11, wherein the stacked amplifier is an amplifier of a cascode structure; the first transistor (41) is a common-source transistor, the input end of the first transistor (41) is a gate of the common-source transistor, the output end of the first transistor (41) is a drain of the common-source transistor, and the bias end of the first transistor (41) is a source of the common-source transistor; and
the second transistor (42) is a common-gate transistor, the input end of the second transistor (42) is a source of the common-gate transistor, the output end of the second transistor (42) is a drain of the common-gate transistor, and the bias end of the second transistor (42) is a gate of the common-gate transistor.

13. The stacked amplifier according to any one of claims 1 to 11, wherein the input end of the first transistor (41) is a base of a common-emitter transistor, the output end of the first transistor (41) is a collector of the common-emitter transistor, and the bias end of the first transistor (41) is an emitter of the common-emitter transistor; and
the input end of the second transistor (42) is an emitter of a common-base transistor, the output end of the second transistor (42) is a collector of the common-base transistor, and the bias end of the second transistor (42) is a base of the common-base transistor.

14. A radio frequency transceiver circuit (10), comprising: an antenna (11), a radio frequency circuit (13), and the stacked amplifier (12) according to any one of claims 1 to 13, wherein the stacked amplifier (12) is connected between the antenna (11) and the radio frequency circuit (13).

15. A communication device, comprising a baseband circuit (20) and the radio frequency transceiver circuit (10)according to claim 14, wherein the baseband circuit (20) is connected to a radio frequency circuit in the radio frequency transceiver circuit (10).

## Patentansprüche

1. Gestapelter Verstärker, der umfasst:
- einen ersten Transistor (41),
- einen zweiten Transistor (42) und
- eine Vorspannschaltung (43),
wobei ein Vorspannende des ersten Transistors (41) geerdet ist, ein Eingangsende des ersten Transistors (41) konfiguriert ist, um ein Eingangssignal zu empfangen, und ein Ausgangsende des ersten Transistors (41) mit einem Eingangsende des zweiten Transistors (42) verbunden ist;
wobei ein Vorspannende des zweiten Transistors (42) über die Vorspannschaltung (43) mit einem Steuerausgangsende einer externen Schaltung verbunden ist, um eine Vorspannung zu empfangen, die durch die externe Schaltung über das Steuerausgangsende ausgegeben wird, und ein Ausgangsende des zweiten Transistors (42) konfiguriert ist, um ein verstärktes Signal auszugeben;
wobei die Vorspannschaltung (43) einen Vorspannwiderstand und eine Vorrichtung mit variabler Impedanz umfasst, die zwischen dem Steuerausgangsende und Masse in Reihe geschaltet sind, und das Vorspannende des zweiten Transistors (42) zwischen dem Vorspannwiderstand und der Vorrichtung mit variabler Impedanz verbunden ist; und
**dadurch gekennzeichnet, dass** die Vorspannschaltung (43) so konfiguriert ist, dass, wenn die Vorspannung eine Aus-Vorspannung ist, eine Impedanz der variablen Impedanz so eingestellt wird, dass eine Aus-Impedanz des zweiten Transistors (42) größer als eine voreingestellte Impedanz ist, um ein Ein-/Aus-Schalten des gestapelten Verstärkers ohne einen zusätzlichen Umschalter zu implementieren, wobei die Aus-Impedanz eine Ausgangsimpedanz des zweiten Transistors (42) unter einer Wirkung der Aus-Vorspannung ist.

2. Gestapelter Verstärker nach Anspruch 1, wobei die Vorrichtung mit variabler Impedanz eine Vorrichtung mit variabler Kapazität umfasst.

3. Gestapelter Verstärker nach Anspruch 2, wobei die Vorrichtung mit variabler Kapazität einen Metall-Oxid-Halbleiter(MOS)-Kondensator umfasst.

4. Gestapelter Verstärker nach Anspruch 3, wobei der MOS-Kondensator ein N-Typ-MOS-Kondensator ist.

5. Gestapelter Verstärker nach Anspruch 4, wobei ein Gate des N-Typ-MOS-Kondensators zwischen dem Vorspannwiderstand und dem Vorspannende des zweiten Transistors (42) verbunden ist und eine Source, ein Drain und ein Substrat des N-Typ-MOS-Kondensators alle geerdet sind.

6. Gestapelter Verstärker nach Anspruch 4, wobei ein Gate des N-Typ-MOS-Kondensators zwischen dem Vorspannwiderstand und dem Vorspannende des zweiten Transistors (42) verbunden ist, sowohl eine Source als auch ein Drain des N-Typ-MOS-Kondensators geerdet sind und ein Substrat des N-Typ-MOS-Kondensators durch Verwenden eines voreingestellten Widerstands geerdet ist.

7. Gestapelter Verstärker nach Anspruch 4, wobei ein Gate des N-Typ-MOS-Kondensators zwischen dem Vorspannwiderstand und dem Vorspannende des zweiten Transistors (42) verbunden ist, sowohl ein Drain als auch ein Substrat des N-Typ-MOS-Kondensators geerdet sind und eine Source des N-Typ-MOS-Kondensators durch Verwenden eines voreingestellten Widerstands geerdet ist.

8. Gestapelter Verstärker nach Anspruch 2, wobei die Vorrichtung mit variabler Kapazität einen Varaktor oder einen geschalteten Kondensator umfasst.

9. Gestapelter Verstärker nach Anspruch 1, wobei die Vorrichtung mit variabler Impedanz eine Vorrichtung mit variabler Induktion umfasst.

10. Gestapelter Verstärker nach einem der Ansprüche 1 bis 9, wobei der gestapelte Verstärker ein Differenzverstärker ist; der Differenzverstärker zwei Single-Ended-Verstärker umfasst und jeder Single-Ended-Verstärker den ersten Transistor (41), den zweiten Transistor (42) und die Vorspannschaltung (43) umfasst; und
ein Differenzeingangsende des Differenzverstärkers das Eingangsende des ersten Transistors (41) in jedem der zwei Single-Ended-Verstärker ist und ein Differenzausgangsende des Differenzverstärkers das Ausgangsende des zweiten Transistors (42) in jedem der zwei Single-Ended-Verstärker ist.

11. Gestapelter Verstärker nach einem der Ansprüche 1 bis 10, wobei der gestapelte Verstärker umfasst: eine Vielzahl von Stufen zweiter Transistoren (42) und eine Vielzahl von Vorspannschaltungen (43), wobei in der Vielzahl von Stufen zweiter Transistoren (42) ein Eingangsende einer ersten Stufe des zweiten Transistors (42) mit dem Ausgangsende des ersten Transistors (41) verbunden ist und ein Eingangsende einer hinteren Stufe des zweiten Transistors (42) mit einem Ausgangsende einer vorderen Stufe des zweiten Transistors (42) verbunden ist; und
ein Vorspannende jeder Stufe des zweiten Transistors (42) über eine Vorspannschaltung (43) mit einem Steuerausgangsende verbunden ist.

12. Gestapelter Verstärker nach einem der Ansprüche 1 bis 11, wobei der gestapelte Verstärker ein Verstärker mit einer Kaskodenstruktur ist; der erste Transistor (41) ein Common-Source-Transistor ist, das Eingangsende des ersten Transistors (41) ein Gate des Common-Source-Transistors ist, das Ausgangsende des ersten Transistors (41) ein Drain des Common-Source-Transistors ist und das Vorspannende des ersten Transistors (41) eine Source des Common-Source-Transistors ist; und
der zweite Transistor (42) ein Common-Gate-Transistor ist, das Eingangsende des zweiten Transistors (42) eine Source des Common-Gate-Transistors ist, das Ausgangsende des zweiten Transistors (42) ein Drain des Common-Gate-Transistors ist und das Vorspannende des zweiten Transistors (42) ein Gate des Common-Gate-Transistors ist.

13. Gestapelter Verstärker nach einem der Ansprüche 1 bis 11, wobei das Eingangsende des ersten Transistors (41) eine Basis eines Transistors in Emitterschaltung ist, das Ausgangsende des ersten Transistors (41) ein Kollektor des Transistors in Emitterschaltung ist und das Vorspannungsende des ersten Transistors (41) ein Emitter des Transistors in Emitterschaltung ist; und
das Eingangsende des zweiten Transistors (42) ein Emitter eines Transistors in Basisschaltung ist, das Ausgangsende des zweiten Transistors (42) ein Kollektor des Transistors in Basisschaltung ist und das Vorspannende des zweiten Transistors (42) eine Basis des Transistors in Basisschaltung ist.

14. Hochfrequenztransceiverschaltung (10), die umfasst: eine Antenne (11), eine Hochfrequenzschaltung (13) und den gestapelten Verstärker (12) nach einem der Ansprüche 1 bis 13, wobei der gestapelte Verstärker (12) zwischen der Antenne (11) und der Hochfrequenzschaltung (13) verbunden ist.

15. Kommunikationsvorrichtung, die eine Basisbandschaltung (20) und die Hochfrequenztransceiverschaltung (10) nach Anspruch 14 umfasst, wobei die Basisbandschaltung (20) mit einer Hochfrequenzschaltung in der Hochfrequenztransceiverschaltung (10) verbunden ist.

## Revendications

1. Amplificateur empilé, comprenant :
- un premier transistor (41),
- un second transistor (42), et
- un circuit de polarisation (43),
dans lequel une extrémité de polarisation du premier transistor (41) est mise à la masse, une extrémité d'entrée du premier transistor (41) est configurée pour recevoir un signal d'entrée, et une extrémité de sortie du premier transistor (41) est connectée à une extrémité d'entrée du second transistor (42) ;
dans lequel une extrémité de polarisation du second transistor (42) est connectée à une extrémité de sortie de commande d'un circuit externe par l'intermédiaire du circuit de polarisation (43), afin de recevoir une tension de polarisation qui est sortie par le circuit externe par l'intermédiaire de l'extrémité de sortie de commande, et une extrémité de sortie du second transistor (42) est configurée pour sortir un signal amplifié ;
dans lequel le circuit de polarisation (43) comprend une résistance de polarisation et un dispositif à impédance variable qui sont connectés en série entre l'extrémité de sortie de commande et la masse, et l'extrémité de polarisation du second transistor (42) est connectée entre la résistance de polarisation et le dispositif à impédance variable ; et
**caractérisé en ce que** le circuit de polarisation (43) est configuré de telle sorte que, si la tension de polarisation est une tension de polarisation à l'arrêt, une impédance de l'impédance variable est réglée de telle sorte qu'une impédance à l'arrêt du second transistor (42) est supérieure à une impédance prédéfinie, de manière à mettre en œuvre la commutation d'état marche/arrêt de l'amplificateur empilé sans un inverseur supplémentaire, dans lequel l'impédance à l'arrêt est une impédance de sortie du second transistor (42) sous l'effet de la tension de polarisation à l'arrêt.

2. Amplificateur empilé selon la revendication 1, dans lequel le dispositif à impédance variable comprend un dispositif capacitif variable.

3. Amplificateur empilé selon la revendication 2, dans lequel le dispositif capacitif variable comprend un condensateur métal-oxyde-semiconducteur, MOS.

4. Amplificateur empilé selon la revendication 3, dans lequel le condensateur MOS est un condensateur MOS de type N.

5. Amplificateur empilé selon la revendication 4, dans lequel une grille du condensateur MOS de type N est connectée entre la résistance de polarisation et l'extrémité de polarisation du second transistor (42), et une source, un drain et un substrat du condensateur MOS de type N sont tous mis à la masse.

6. Amplificateur empilé selon la revendication 4, dans lequel une grille du condensateur MOS de type N est connectée entre la résistance de polarisation et l'extrémité de polarisation du second transistor (42), une source et un drain du condensateur MOS de type N sont tous deux mis à la masse, et un substrat du condensateur MOS de type N est mis à la masse en utilisant une résistance prédéfinie.

7. Amplificateur empilé selon la revendication 4, dans lequel une grille du condensateur MOS de type N est connectée entre la résistance de polarisation et l'extrémité de polarisation du second transistor (42), un drain et un substrat du condensateur MOS de type N sont tous deux mis à la masse, et une source du condensateur MOS de type N est mise à la masse en utilisant une résistance prédéfinie.

8. Amplificateur empilé selon la revendication 2, dans lequel le dispositif capacitif variable comprend un varactor ou un condensateur commuté.

9. Amplificateur empilé selon la revendication 1, dans lequel le dispositif à impédance variable comprend un dispositif inductif variable.

10. Amplificateur empilé selon l'une quelconque des revendications 1 à 9, dans lequel l'amplificateur empilé est un amplificateur différentiel ; l'amplificateur différentiel comprend deux amplificateurs asymétriques, et chaque amplificateur asymétrique comprend le premier transistor (41), le second transistor (42), et le circuit de polarisation (43) ; et
une extrémité d'entrée différentielle de l'amplificateur différentiel est l'extrémité d'entrée du premier transistor (41) dans chacun des deux amplificateurs asymétriques, et une extrémité de sortie différentielle de l'amplificateur différentiel est l'extrémité de sortie du second transistor (42) dans chacun des deux amplificateurs asymétriques.

11. Amplificateur empilé selon l'une quelconque des revendications 1 à 10, dans lequel l'amplificateur empilé comprend : une pluralité d'étages de seconds transistors (42) et une pluralité de circuits de polarisation (43), dans lequel, dans la pluralité d'étages de seconds transistors (42), une extrémité d'entrée d'un premier étage de second transistor (42) est connectée à l'extrémité de sortie du premier transistor (41), et une extrémité d'entrée d'un étage arrière de second transistor (42) est connectée à une extrémité de sortie d'un étage avant de second transistor (42) ; et
une extrémité de polarisation de chaque étage de second transistor (42) est connectée à l'extrémité de sortie de commande par l'intermédiaire d'un circuit de polarisation (43).

12. Amplificateur empilé selon l'une quelconque des revendications 1 à 11, dans lequel l'amplificateur empilé est un amplificateur d'une structure cascode ; le premier transistor (41) est un transistor à source commune, l'extrémité d'entrée du premier transistor (41) est une grille du transistor à source commune, l'extrémité de sortie du premier transistor (41) est un drain du transistor à source commune, et l'extrémité de polarisation du premier transistor (41) est une source du transistor à source commune ; et
le second transistor (42) est un transistor à grille commune, l'extrémité d'entrée du second transistor (42) est une source du transistor à grille commune, l'extrémité de sortie du second transistor (42) est un drain du transistor à grille commune, et l'extrémité de polarisation du second transistor (42) est une grille du transistor à grille commune.

13. Amplificateur empilé selon l'une quelconque des revendications 1 à 11, dans lequel l'extrémité d'entrée du premier transistor (41) est une base d'un transistor à émetteur commun, l'extrémité de sortie du premier transistor (41) est un collecteur du transistor à émetteur commun, et l'extrémité de polarisation du premier transistor (41) est un émetteur du transistor à émetteur commun ; et
l'extrémité d'entrée du second transistor (42) est un émetteur d'un transistor à base commune, l'extrémité de sortie du second transistor (42) est un collecteur du transistor à base commune, et l'extrémité de polarisation du second transistor (42) est une base du transistor à base commune.

14. Circuit émetteur-récepteur radiofréquence (10), comprenant : une antenne (11), un circuit radiofréquence (13), et l'amplificateur empilé (12) selon l'une quelconque des revendications 1 à 13, dans lequel l'amplificateur empilé (12) est connecté entre l'antenne (11) et le circuit radiofréquence (13).

15. Dispositif de communication, comprenant un circuit de bande de base (20) et le circuit émetteur-récepteur radiofréquence (10) selon la revendication 14, dans lequel le circuit de bande de base (20) est connecté à un circuit radiofréquence dans le circuit émetteur-récepteur radiofréquence (10).
